(19) Europäisches Patentamt
European Patent Office
Office européen des brevets

(11) EP 4 717 734 A1

(12) EUROPEAN PATENT APPLICATION
published in accordance with Art. 153(4) EPC

(43) Date of publication:
**01.04.2026 Bulletin 2026/14**

(21) Application number: **24810829.2**

(22) Date of filing: **24.04.2024**

(51) International Patent Classification (IPC):
***C08L 79/00*** *(2006.01)* ***B32B 15/08*** *(2006.01)*
***B32B 27/00*** *(2006.01)* ***B32B 27/18*** *(2006.01)*
***C08J 5/24*** *(2006.01)* ***C08K 5/5399*** *(2006.01)*
***C08L 9/00*** *(2006.01)* ***C08L 63/00*** *(2006.01)*
***H05K 1/03*** *(2006.01)*

(52) Cooperative Patent Classification (CPC):
**B32B 15/08; B32B 27/00; B32B 27/18; C08J 5/24; C08K 5/5399; C08L 9/00; C08L 63/00; C08L 79/00; H05K 1/03**

(86) International application number:
**PCT/JP2024/016070**

(87) International publication number:
**WO 2024/241821 (28.11.2024 Gazette 2024/48)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **22.05.2023 JP 2023083936**

(71) Applicant: **RESONAC CORPORATION**
**Tokyo 105-7325 (JP)**

(72) Inventors:
- **SUNAIRI, Yoshiya**
  **Tokyo 105-7325 (JP)**
- **SAKAMOTO, Norihiko**
  **Tokyo 105-7325 (JP)**
- **SUTOU, Kyousuke**
  **Tokyo 105-7325 (JP)**
- **SHIMAOKA, Shinji**
  **Tokyo 105-7325 (JP)**

(74) Representative: **Hoffmann Eitle**
**Patent- und Rechtsanwälte PartmbB**
**Arabellastraße 30**
**81925 München (DE)**

# (54) RESIN COMPOSITION, PREPREG, LAMINATED PLATE, PRINTED WIRING BOARD, AND SEMICONDUCTOR PACKAGE

(57) The present invention relates to a resin composition containing (A) a siloxane-modified maleimide resin, (B) a conjugated diene-based polymer, and (C) a phosphorus-based flame retardant, and a prepreg, a laminated plate, a printed wiring board, and a semiconductor package using the resin composition.

EP 4 717 734 A1

## Description

Technical Field

The present embodiment relates to a resin composition, a prepreg, a laminated plate, a printed wiring board, and a semiconductor package.

Background Art

In recent years, with the progress of high density and high integration of wiring density of a printed wiring board, particularly in the application of a semiconductor package substrate, "warpage" caused by a difference in coefficient of thermal expansion between a semiconductor element and a substrate at the time of mounting a component and assembling a package has become a major problem. Warpage is considered to be one of the factors that cause connection failure between a semiconductor element and a printed wiring board, and reduction of the warpage is required.

One of the causes of the warpage is a difference in coefficient of thermal expansion between the semiconductor element and the printed wiring board. In general, since the coefficient of thermal expansion of the printed wiring board is larger than that of the semiconductor element, a stress is generated due to a thermal history or the like applied at the time of mounting the semiconductor element, thereby causing warpage. Therefore, in order to suppress the warpage of the semiconductor package, it is necessary to reduce the coefficient of thermal expansion of the printed wiring board to reduce the difference from the coefficient of thermal expansion of the semiconductor element.

Here, it is generally known that the coefficient of thermal expansion of a prepreg obtained by impregnating a glass cloth with a resin composition follows the Schapery equation represented by the following equation.

$$A \approx (ArErFr + AgEgFg) / (ErFr + EgFg)$$

(In the above equation, A represents the coefficient of thermal expansion of the prepreg, Ar represents the coefficient of thermal expansion of the resin composition, Er represents the elastic modulus of the resin composition, Fr represents the volume fraction of the resin composition, Ag represents the coefficient of thermal expansion of the glass cloth, Eg represents the elastic modulus of the glass cloth, and Fg represents the volume fraction of the glass cloth.)

From the above-described Schapery equation, it is considered that when glass cloths having the same physical properties are used at an arbitrary volume fraction, the thermal expansion of the prepreg can be reduced by reducing the elastic modulus and the coefficient of thermal expansion of the resin composition.

PTL 1 discloses a resin composition containing an acrylic polymer as a resin composition having a low elastic modulus.

Citation List

Patent Literature

PTL 1:WO 2017/195902

Summary of Invention

Technical Problem

As in the technique of PTL 1, low elasticity can be achieved by using a thermoplastic resin such as an acrylic polymer, but the minimum melt viscosity tends to be high due to containing the thermoplastic resin. When the minimum melt viscosity is high, in the case of a form of a prepreg or the like, there is a case where a problem occurs in moldability, such as deterioration of embeddability of a circuit. Therefore, development of a resin composition having a low thermal expansion property and a low minimum melt viscosity has been desired.

In view of such a current situation, an object of the present embodiment is to provide a resin composition having excellent low thermal expansion property and minimum melt viscosity, and a prepreg, a laminated plate, a printed wiring board, and a semiconductor package using the resin composition.

Solution to Problem

In order to solve the above problems, the present inventors have conducted intensive studies, and as a result,

have found that the above problems can be solved by the following present embodiment, and have completed the present embodiment.

That is, the present embodiment relates to the following [1] to [13].

[1] A resin composition containing (A) a siloxane-modified maleimide resin, (B) a conjugated diene-based polymer, and (C) a phosphorus-based flame retardant.
[2] The resin composition according to the item [1], in which the component (C) has a melting point of 40 to 200°C.
[3] The resin composition according to the item [1] or [2], in which the component (C) is a phosphazene compound.
[4] The resin composition according to any one of the items [1] to [3], in which a content of the component (C) is 3% to 40% by mass with respect to a total amount of solid content (100% by mass) in the resin composition.
[5] The resin composition according to any one of the items [1] to [4], in which the component (B) is a butadiene-based polymer.
[6] The resin composition according to any one of the items [1] to [5], further containing (D) an epoxy resin.
[7] A prepreg containing the resin composition according to any one of the items [1] to [6] and a fiber substrate.
[8] The prepreg according to the item [7], in which the fiber substrate is a glass cloth.
[9] The prepreg according to the item [8], in which the glass cloth is composed of S-glass.
[10] The prepreg according to the item [8] or [9], in which a basis weight of the glass cloth is 10 to 210 $g/m^2$.
[11] A laminated plate including a cured product of the resin composition according to any one of the items [1] to [6], and a metal foil.
[12] A printed wiring board including a cured product of the resin composition according to any one of the items [1] to [6].
[13] A semiconductor package including the printed wiring board according to the item [12], and a semiconductor element.

## Advantageous Effects of Invention

According to the present embodiment, it is possible to provide a resin composition having excellent low thermal expansion property and minimum melt viscosity, and a prepreg, a laminated plate, a printed wiring board, and a semiconductor package using the resin composition.

## Description of Embodiments

In the description herein, a numerical range indicated by using "to" indicates a range including numerical values described before and after "to" as a minimum value and a maximum value, respectively.

For example, the expression of a numerical range "X to Y" (X and Y are real numbers) means a numerical range in which the range is equal to or greater than X and equal to or less than Y. Further, the description of "X or more" in the description herein means X and a numerical value exceeding X. Furthermore, the description of "Y or less" in the description herein means Y and a numerical value less than Y.

The lower limit value and the upper limit value of the numerical range described in the description herein can be arbitrarily combined with the lower limit value or the upper limit value of another numerical range, respectively.

In the numerical range described in the description herein, the lower limit value or the upper limit value of the numerical range may be replaced with a value shown in Examples.

Each component and material exemplified in the description herein may be used alone or may be used in combination of two or more kinds thereof, unless otherwise specified.

In the description herein, when a plurality of substances corresponding to each component are present in a resin composition, the content of each component in the resin composition means the total amount of the plurality of substances present in the resin composition, unless otherwise specified.

In the description herein, the "solid content" means a component other than a solvent, and a component that is liquid at 25°C is also regarded as a solid content.

The expression "containing XX" described in the description herein, when XX can react, includes both the case where XX may be contained in a reacted state, and the case where XX may be simply contained.

The weight-average molecular weight (Mw) in the description herein means a value measured by gel permeation chromatography (GPC) in terms of polystyrene. To be specific, the weight-average molecular weight (Mw) in the description herein can be measured by a method described in Examples.

In the description herein, the "semi-cured product" has the same meaning as a resin composition in a B-stage state in JIS K 6800 (2006), and the "cured product" has the same meaning as a resin composition in a C-stage state in JIS K 6800 (2006).

The action mechanism described in the description herein is a conjecture, and does not limit the mechanism by

which the effect of the present embodiment is exhibited.

An aspect in which the matters described in the description herein are arbitrarily combined is also included in the present embodiment.

[Resin Composition]

The resin composition of the present embodiment is a resin composition containing (A) a siloxane-modified maleimide resin, (B) a conjugated diene-based polymer, and (C) a phosphorus-based flame retardant.

Although the details of the reason why the resin composition of the present embodiment is excellent in low thermal expansion property and minimum melt viscosity are not clear, it is presumed as follows.

It is presumed that since the resin composition of the present embodiment contains the siloxane structure contained in the component (A) and the conjugated diene-based polymer (B), which contribute to the reduction of the elastic modulus, the thermal expansion of the cured product of the thermosetting component can be alleviated, and the low thermal expansion property is obtained. In addition, it is considered that one of the reasons why the minimum melt viscosity became low is that the resin composition containing the components (A) to (C) has excellent uniformity at the time of melting.

Hereinafter, each component contained in the resin composition of the present embodiment will be described in order.

<(A) Siloxane-Modified Maleimide Resin>

The component (A) is not particularly limited as long as it is obtained by modifying a maleimide resin with a siloxane compound.

The siloxane-modified maleimide resin (A) may be used alone or may be used in combination of two or more kinds thereof.

The siloxane-modified maleimide resin (A) preferably has a structure derived from a maleimide resin having one or more N-substituted maleimide groups [hereinafter sometimes referred to as "maleimide resin (AX)" or "component (AX)"] and a structure derived from a siloxane compound having two primary amino groups [hereinafter sometimes referred to as "siloxane diamine"].

<<Structure Derived from Maleimide Resin (AX)>>

Examples of the structure derived from the maleimide resin (AX) include a structure formed by a Michael addition reaction between at least one N-substituted maleimide group of the N-substituted maleimide groups of the maleimide resin (AX) and the primary amino group of the siloxane diamine.

The structure derived from the maleimide resin (AX) contained in the siloxane-modified maleimide resin (A) may be one kind alone, or may be two or more kinds.

The content of the structure derived from the maleimide resin (AX) in the siloxane-modified maleimide resin (A) is preferably 5 to 95% by mass, more preferably 30 to 93% by mass, and still more preferably 60 to 90% by mass, from the viewpoint of heat resistance.

- Maleimide Resin (AX) -

The maleimide resin (AX) is preferably an aromatic maleimide resin having two or more N-substituted maleimide groups, and more preferably an aromatic bismaleimide resin having two N-substituted maleimide groups, from the viewpoint of adhesiveness to a conductor and heat resistance.

In the description herein, the "aromatic maleimide resin" means a compound having an N-substituted maleimide group directly bonded to an aromatic ring. Further, in the description herein, the "aromatic bismaleimide resin" means a compound having two N-substituted maleimide groups directly bonded to an aromatic ring. Furthermore, in the description herein, the "aromatic polymaleimide resin" means a compound having three or more N-substituted maleimide groups directly bonded to an aromatic ring. In addition, in the description herein, the "aliphatic maleimide resin" means a compound having an N-substituted maleimide group directly bonded to an aliphatic hydrocarbon.

As the maleimide resin (AX), a maleimide resin represented by the following general formula (A-1) is preferable.

[Chem. 1]

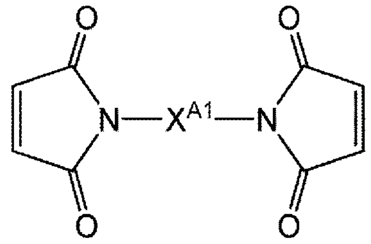

(A-1)

(In the formula, $X^{A1}$ is a divalent organic group.)

Examples of the divalent organic group represented by $X^{A1}$ in the general formula (A-1) include a divalent organic group represented by the following general formula (A-2), a divalent organic group represented by the following general formula (A-3), a divalent organic group represented by the following general formula (A-4), a divalent organic group represented by the following general formula (A-5), and a divalent organic group represented by the following general formula (A-6).

[Chem. 2]

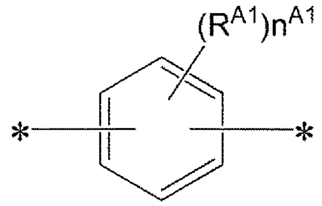

(A-2)

(In the formula, $R^{A1}$ is an aliphatic hydrocarbon group having 1 to 5 carbon atoms or a halogen atom; $n^{A1}$ is an integer of 0 to 4; and * represents a bonding site.)

Examples of the aliphatic hydrocarbon group having 1 to 5 carbon atoms represented by $R^{A1}$ in the general formula (A-2) include an alkyl group having 1 to 5 carbon atoms such as a methyl group, an ethyl group, a n-propyl group, an isopropyl group, a n-butyl group, an isobutyl group, a t-butyl group, and a n-pentyl group; an alkenyl group having 2 to 5 carbon atoms; and an alkynyl group having 2 to 5 carbon atoms. The aliphatic hydrocarbon group having 1 to 5 carbon atoms may be either linear or branched.

Examples of the halogen atom include a fluorine atom, a chlorine atom, a bromine atom, and an iodine atom.

When $n^{A1}$ is an integer of 2 or more, a plurality of $R^{A1}$'s may be the same as or different from each other.

[Chem. 3]

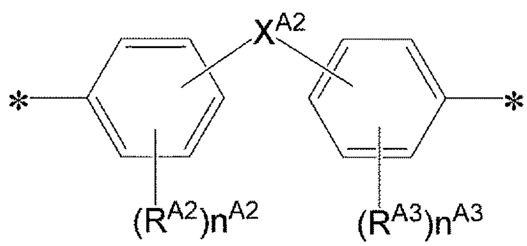

(A-3)

(In the formula, $R^{A2}$ and $R^{A3}$ are each independently an aliphatic hydrocarbon group having 1 to 5 carbon atoms or a halogen atom; $X^{A2}$ is an alkylene group having 1 to 5 carbon atoms, an alkylidene group having 2 to 5 carbon atoms, an ether group, a sulfide group, a sulfonyl group, a carbonyloxy group, a keto group, a single bond, or a divalent organic group represented by the following general formula (A-3-1); $n^{A2}$ and $n^{A3}$ are each independently an integer of 0 to 4; and * represents a bonding site.)

Examples of the aliphatic hydrocarbon group having 1 to 5 carbon atoms and the halogen atom represented by $R^{A2}$ and $R^{A3}$ in the general formula (A-3) are the same as those described above for $R^{A1}$.

Examples of the alkylene group having 1 to 5 carbon atoms represented by $X^{A2}$ in the general formula (A-3) include a methylene group, a 1,2-dimethylene group, a 1,3-trimethylene group, a 1,4-tetramethylene group, and a 1,5-pentamethylene group.

Examples of the alkylidene group having 2 to 5 carbon atoms represented by $X^{A2}$ in the general formula (A-3) include an ethylidene group, a propylidene group, an isopropylidene group, a butylidene group, an isobutylidene group, a pentylidene group, and an isopentylidene group.

When $n^{A2}$ or $n^{A3}$ is an integer of 2 or more, a plurality of $R^{A2}$'s or a plurality of $R^{A3}$'s may be the same as or different from each other.

The divalent organic group represented by the general formula (A-3-1) represented by $X^{A2}$ in the general formula (A-3) is as follows.

[Chem. 4]

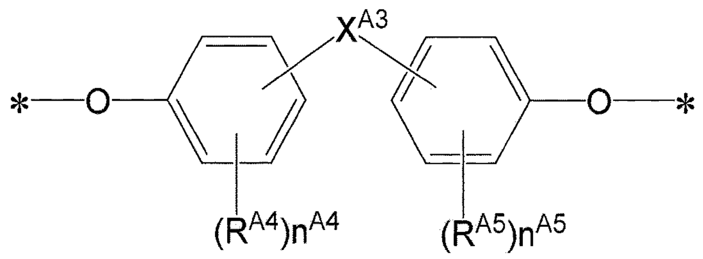

(A-3-1)

(In the formula, $R^{A4}$ and $R^{A5}$ are each independently an aliphatic hydrocarbon group having 1 to 5 carbon atoms or a halogen atom; $X^{A3}$ is an alkylene group having 1 to 5 carbon atoms, an alkylidene group having 2 to 5 carbon atoms, an ether group, a sulfide group, a sulfonyl group, a carbonyloxy group, a keto group, or a single bond; $n^{A4}$ and $n^{A5}$ are each independently an integer of 0 to 4; and * represents a bonding site.)

Examples of the aliphatic hydrocarbon group having 1 to 5 carbon atoms and the halogen atom represented by $R^{A4}$ and $R^{A5}$ in the general formula (A-3-1) are the same as those described above for $R^{A1}$.

Examples of the alkylene group having 1 to 5 carbon atoms and the alkylidene group having 2 to 5 carbon atoms represented by $X^{A3}$ in the general formula (A-3-1) are the same as those described above for $X^{A2}$.

$n^{A4}$ and $n^{A5}$ in the general formula (A-3-1) are each independently an integer of 0 to 4, and both of them are preferably an integer of 0 to 2, more preferably 0 or 1, and still more preferably 0.

When $n^{A4}$ or $n^{A5}$ is an integer of 2 or more, a plurality of $R^{A4}$'s or a plurality of $R^{A5}$'s may be the same as or different from each other.

[Chem. 5]

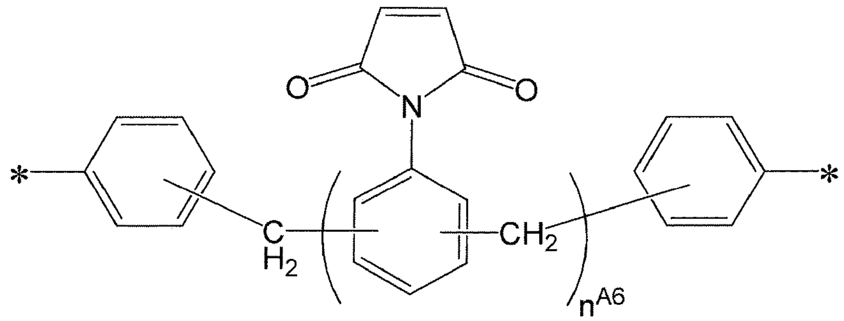

(A-4)

(In the formula, $n^{A6}$ is an integer of 0 to 10; and * represents a bonding site.)

[Chem. 6]

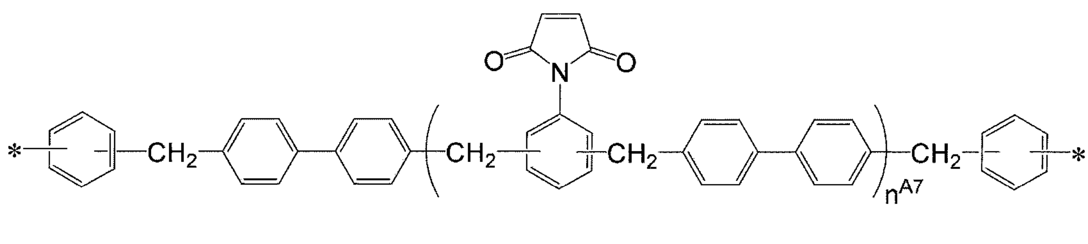

(A-5)

(In the formula, $n^{A7}$ is a number of 0 to 5; and * represents a bonding site.)

[Chem. 7]

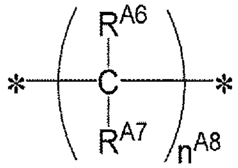 (A-6)

(In the formula, $R^{A6}$ and $R^{A7}$ are each independently a hydrogen atom or an aliphatic hydrocarbon group having 1 to 5 carbon atoms; $n^{A8}$ is an integer of 1 to 8; and * represents a bonding site.)

Examples of the aliphatic hydrocarbon group having 1 to 5 carbon atoms and the halogen atom represented by $R^{A6}$ and $R^{A7}$ in the general formula (A-6) are the same as those described above for $R^{A1}$.

In the case where $n^{A8}$ in the general formula (A-6) is an integer of 2 or more, a plurality of $R^{A6}$'s or a plurality of $R^{A7}$'s may be the same as or different from each other.

Examples of the maleimide resin (AX) include an aromatic bismaleimide resin, an aromatic polymaleimide resin, and an aliphatic maleimide resin.

Examples of the maleimide resin (AX) include bis(4-maleimidophenyl)methane, m-phenylenebismaleimide, 2,2-bis[4-(4-maleimidophenoxy)phenyl]propane, 4-methyl-1,3-phenylenebismaleimide, 3,3'-dimethyl-5,5'-diethyl-4,4'-diphenylmethanebismaleimide, polyphenylmethanemaleimide, a biphenyl aralkyl type maleimide, and an aromatic bismaleimide resin having an indane skeleton. Among these, 2,2-bis[4-(4-maleimidophenoxy)phenyl]propane is preferable.

<<Structure Derived from Siloxane Diamine>>

Examples of the structure derived from a siloxane diamine include a structure formed by a Michael addition reaction between one or both of the two primary amino groups of the siloxane diamine and the N-substituted maleimide group of the maleimide resin (AX).

The structure derived from a siloxane diamine contained in the siloxane-modified maleimide resin (A) may be one kind alone, or may be two or more kinds.

The content of the structure derived from a siloxane diamine in the siloxane-modified maleimide resin (A) is preferably 5 to 95% by mass, more preferably 7 to 70% by mass, and still more preferably 10 to 40% by mass, from the viewpoint of low thermal expansion property.

- Siloxane Diamine -

The siloxane diamine is not particularly limited as long as it is a siloxane compound having two primary amino groups.

The siloxane diamine preferably contains a divalent group having a structure represented by the following general formula (A-7).

[Chem. 8]

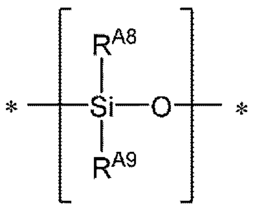 (A-7)

(In the formula, $R^{A8}$ and $R^{A9}$ are each independently an aliphatic hydrocarbon group having 1 to 5 carbon atoms, a phenyl group, or a substituted phenyl group; and * represents a bonding site.)

Examples of the aliphatic hydrocarbon group having 1 to 5 carbon atoms represented by $R^{A8}$ and $R^{A9}$ in the general formula (A-7) include an alkyl group having 1 to 5 carbon atoms such as a methyl group, an ethyl group, a n-propyl group, an isopropyl group, a n-butyl group, an isobutyl group, a t-butyl group, and a n-pentyl group; an alkenyl group having 2 to 5 carbon atoms; and an alkynyl group having 2 to 5 carbon atoms. The aliphatic hydrocarbon group having 1 to 5 carbon atoms may be either linear or branched. As the aliphatic hydrocarbon group having 1 to 5 carbon atoms, an aliphatic hydrocarbon group having 1 to 3 carbon atoms is preferable, an alkyl group having 1 to 3 carbon atoms is more preferable,

and a methyl group is still more preferable.

Examples of the substituent of the phenyl group in the substituted phenyl group represented by $R^{A8}$ and $R^{A9}$ include the above-described aliphatic hydrocarbon group having 1 to 5 carbon atoms.

The siloxane diamine is preferably a silicone compound having a primary amino group at both terminals, and more preferably a compound represented by the following general formula (A-8).

[Chem. 9]

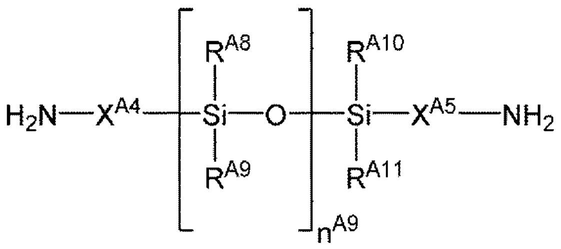

(A-8)

(In the formula, $R^{A8}$ and $R^{A9}$ are the same as those in the general formula (A-7); $R^{A10}$ and $R^{A11}$ are each independently an aliphatic hydrocarbon group having 1 to 5 carbon atoms, a phenyl group, or a substituted phenyl group; $X^{A4}$ and $X^{A5}$ are each independently a divalent organic group; and $n^{A9}$ is an integer of 2 to 100.)

Examples of the aliphatic hydrocarbon group having 1 to 5 carbon atoms represented by $R^{A10}$ and $R^{A11}$ in the general formula (A-8) are the same as those described above for $R^{A8}$ and $R^{A9}$.

Examples of the divalent organic group represented by $X^{A4}$ and $X^{A5}$ in the general formula (A-8) include an alkylene group, an alkenylene group, an alkynylene group, an arylene group, -O-, and a divalent linking group obtained by combining these groups.

Examples of the alkylene group include an alkylene group having 1 to 10 carbon atoms, such as a methylene group, an ethylene group, and a propylene group.

Examples of the alkenylene group include an alkenylene group having 2 to 10 carbon atoms.

Examples of the alkynylene group include an alkynylene group having 2 to 10 carbon atoms.

Examples of the arylene group include an arylene group having 6 to 20 carbon atoms, such as a phenylene group and a naphthylene group.

Among these, as $X^{A4}$ and $X^{A5}$, an alkylene group and an arylene group are preferable, and an alkylene group is more preferable.

In the general formula (A-8), $n^{A9}$ is an integer of 2 to 100, preferably an integer of 2 to 50, more preferably an integer of 3 to 40, and still more preferably an integer of 5 to 30. When $n^{A9}$ is an integer of 2 or more, a plurality of $R^{A8}$'s or a plurality of $R^{A9}$'s may be the same as or different from each other.

The primary amino group equivalent of the siloxane diamine is preferably 300 to 2,000 g/mol, more preferably 400 to 1,500 g/mol, and still more preferably 500 to 1,000 g/mol.

<<(A) Method for Producing Siloxane-Modified Maleimide Resin>>

The siloxane-modified maleimide resin (A) can be produced, for example, by subjecting the maleimide resin (AX) and a siloxane diamine to a Michael addition reaction in an organic solvent.

The reaction temperature of the Michael addition reaction is preferably 50 to 160°C, more preferably 60 to 150°C, and still more preferably 70 to 140°C, from the viewpoint of workability such as reaction rate, suppression of gelation of the product during the reaction, and the like.

The reaction time of the Michael addition reaction is preferably 0.5 to 10 hours, more preferably 1 to 8 hours, and still more preferably 2 to 6 hours, from the viewpoint of productivity and sufficient progress of the reaction.

When the maleimide resin (AX) is reacted with the siloxane diamine, a reaction catalyst may be used, if necessary.

However, these reaction conditions can be appropriately adjusted according to the types of raw materials used and the like, and are not particularly limited.

The weight-average molecular weight (Mw) of the siloxane-modified maleimide resin (A) is preferably 400 to 10,000, more preferably 1,000 to 5,000, and still more preferably 2,000 to 3,000, from the viewpoint of handleability and moldability.

In the resin composition of the present embodiment, the content of the siloxane-modified maleimide resin (A) is preferably 20 to 95% by mass, more preferably 40 to 90% by mass, and still more preferably 60 to 80% by mass with respect to the total amount (100% by mass) of the resin components in the resin composition.

When the content of the siloxane-modified maleimide resin (A) is within the above range, the heat resistance, the low thermal expansion property, the moldability, and the adhesiveness to a copper foil tend to be more easily improved.
Here, in the description herein, the "resin component" means a resin and a compound which forms a resin by a curing reaction. Examples of the resin component include the component (A), the component (B), and the component (D). On the other hand, the component (C), the component (E), and the curing accelerator (F) are not included in the resin component.
The content of the resin component in the resin composition of the present embodiment is preferably 5 to 70% by mass, more preferably 10 to 60% by mass, and still more preferably 20 to 40% by mass with respect to the total amount of solid content (100% by mass) of the resin composition.
When the content of the resin component is equal to or more than the lower limit value, the heat resistance, the moldability, the processability, and the adhesiveness to a copper foil tend to be more easily improved. On the other hand, when the content of the resin component is equal to or less than the upper limit value, the low thermal expansion property tends to be more easily improved.

<(B) Conjugated Diene-Based Polymer>

The resin composition of the present embodiment further contains (B) a conjugated diene-based polymer.
The resin composition of the present embodiment has excellent low thermal expansion property by containing the conjugated diene-based polymer (B).
In the description herein, the "conjugated diene-based polymer" means a polymer containing a structural unit derived from a conjugated diene compound.
The conjugated diene-based polymer (B) may be used alone or may be used in combination of two or more kinds thereof.
Examples of the conjugated diene compound which is a monomer component of the conjugated diene-based polymer include 1,3-butadiene, isoprene, 1,3-pentadiene, 2,3-dimethyl-1,3-butadiene, 2-phenyl-1,3-butadiene, and 1,3-hexadiene. Among these, the conjugated diene-based polymer (B) is preferably a butadiene-based polymer.
In the description herein, the butadiene-based polymer means a polymer containing a structural unit derived from 1,3-butadiene or a 1,3-butadiene derivative. In addition, in the description herein, polybutadiene means a polymer of 1,3-butadiene or a 1,3-butadiene derivative.
The conjugated diene-based polymer (B) may be a polymer of one conjugated diene compound or a copolymer of two or more conjugated diene compounds.
In addition, the conjugated diene-based polymer (B) may be a copolymer of one or more kinds of conjugated diene compounds and one or more kinds of monomers other than the conjugated diene compound.
When the conjugated diene-based polymer (B) is a copolymer, the polymerization mode is not particularly limited, and may be any of random polymerization, block polymerization, and graft polymerization.
As the conjugated diene-based polymer (B), maleic acid-modified polybutadiene obtained by modifying polybutadiene having a 1,2-vinyl group with maleic acid is preferable from the viewpoint of low thermal expansion property and minimum melt viscosity.
The ratio of the structural unit having a 1,2-vinyl group in all the structural units of the polybutadiene having a 1,2-vinyl group modified with maleic acid is preferably 5 to 50%, more preferably 10 to 40%, and still more preferably 12 to 30% on a molar basis.
The average number of structural units derived from maleic acid in one molecule of the maleic acid-modified polybutadiene is preferably 0.5 to 10, more preferably 0.8 to 5, and still more preferably 1 to 3.
The acid value of the maleic acid-modified polybutadienes is preferably 2 to 20 $mgCH_3ONa/g$, more preferably 5 to 15 $mgCH_3ONa/g$, and still more preferably 7 to 13 $mgCH_3ONa/g$.
The weight-average molecular weight (Mw) of the conjugated diene-based polymer (B) is preferably 500 to 5,000, more preferably 1,000 to 4,000, and still more preferably 1,200 to 3,500, from the viewpoint of compatibility with other resins, dielectric characteristics, and heat resistance.
The weight-average molecular weight (Mw) of the conjugated diene-based polymer (B) may be 3,000 or less, may be 2,500 or less, or may be 2,000 or less from the viewpoint of the minimum melt viscosity.
The content of the conjugated diene-based polymer (B) in the resin composition of the present embodiment is preferably 5 to 70% by mass, more preferably 10 to 50% by mass, and still more preferably 20 to 30% by mass, with respect to the total amount (100% by mass) of the resin components in the resin composition.
When the content of the conjugated diene-based polymer (B) is equal to or more than the above lower limit value, the low thermal expansion property tends to be more easily improved. On the other hand, when the content of the conjugated diene-based polymer (B) is equal to or less than the above upper limit value, the heat resistance and flame retardancy tend to be more favorable.

<(C) Phosphorus-Based Flame Retardant>

The resin composition of the present embodiment further contains (C) a phosphorus-based flame retardant.

The resin composition of the present embodiment tends to have a low minimum melt viscosity by containing the component (C).

The phosphorus-based flame retardant (C) may be used alone or may be used in combination of two or more kinds thereof.

The melting point of the phosphorus-based flame retardant (C) is preferably 40 to 200°C, more preferably 60 to 150°C, still more preferably 70 to 120°C, particularly preferably 80 to 100°C, from the viewpoint of the minimum melt viscosity.

The melting point of the phosphorus-based flame retardant (C) can be measured with a differential scanning calorimetry (DSC measurement) device.

Examples of the phosphorus-based flame retardant (C) include a phosphazene compound, a phosphate ester compound, and a phosphaphenanthrene compound. Among these, a phosphazene compound is preferable from the viewpoint of the minimum melt viscosity.

(Phosphazene Compound)

The phosphazene compound preferably has a structural unit represented by the following general formula (C-1).

[Chem. 10]

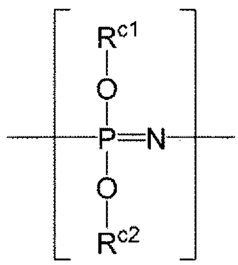

(C-1)

(In the formula, $R^{c1}$ and $R^{c2}$ each independently represent an organic group having 1 to 20 carbon atoms.)

Examples of the organic group having 1 to 20 carbon atoms represented by $R^{c1}$ and $R^{c2}$ in the above general formula (C-1) include an aliphatic hydrocarbon group having 1 to 20 carbon atoms and an aromatic hydrocarbon group having 6 to 20 carbon atoms.

Examples of the aliphatic hydrocarbon group having 1 to 20 carbon atoms as the organic group having 1 to 20 carbon atoms represented by $R^{c1}$ and $R^{c2}$ include an alkyl group having 1 to 20 carbon atoms, an alkenyl group having 2 to 20 carbon atoms, and an alkynyl group having 2 to 20 carbon atoms. The aliphatic hydrocarbon group may be linear, branched or cyclic.

Examples of the alkyl group having 1 to 20 carbon atoms include a methyl group, an ethyl group, an n-propyl group, an isopropyl group, an n-butyl group, an isobutyl group, a t-butyl group, an n-pentyl group, a 2-ethylhexyl group, and a cyclohexyl group. Examples of the alkenyl group having 2 to 20 carbon atoms include a vinyl group, a propenyl group, and a butenyl group. Examples of the alkynyl group having 2 to 20 carbon atoms include a 2-propynyl group, and a 3-butynyl group.

The aliphatic hydrocarbon group having 1 to 20 carbon atoms may have a substituent or may not have a substituent. Examples of the substituent include a hydroxy group, a carboxy group, a halogen atom, an aromatic hydrocarbon group, an acyl group, an alkoxy group, and groups in which these substituents are linked. When the aliphatic hydrocarbon group has a substituent, the number of carbon atoms in the substituent is also included in the above number of carbon atoms.

The aromatic hydrocarbon group having 6 to 20 carbon atoms, which is exemplified as the organic group having 1 to 20 carbon atoms represented by $R^{c1}$ and $R^{c2}$, preferably has 6 to 15 carbon atoms, and more preferably has 6 to 10 carbon atoms.

Examples of the aromatic hydrocarbon group having 6 to 20 carbon atoms include a phenyl group, a naphthyl group, a biphenyl group, and an anthranil group.

The aromatic hydrocarbon group having 6 to 20 carbon atoms may have a substituent or may not have a substituent. Examples of the substituent include a hydroxy group, a carboxy group, a halogen atom, an aliphatic hydrocarbon group, an acyl group, an alkoxy group, a cyano group, and groups in which these substituents are linked. As the substituent, a cyano group is preferable. Note that when the aromatic hydrocarbon group has a substituent, the

number of carbon atoms in the substituent is also included in the above number of carbon atoms.

Among these, the organic group having 1 to 20 carbon atoms represented by $R^{c1}$ and $R^{c2}$ is preferably an aromatic hydrocarbon group having 6 to 20 carbon atoms, more preferably an unsubstituted phenyl group and a phenyl group having a substituent, and still more preferably an unsubstituted phenyl group and a cyanophenyl group.

The phosphazene compound may be a linear phosphazene compound or may be a cyclic phosphazene compound, however a cyclic phosphazene compound is preferable.

As the cyclic phosphazene compound, a phosphazene compound represented by the following general formula (C-2-1) is preferable, and a phosphazene compound represented by the following general formula (C-2-2) is more preferable.

[Chem. 1]

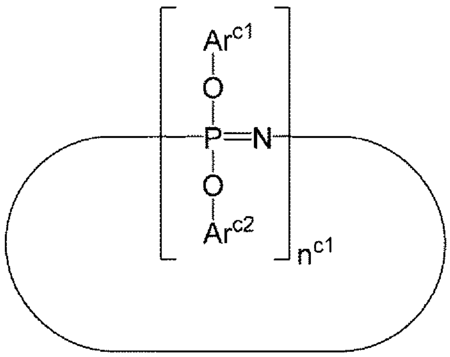

(C-2-1)

(In the formula, $Ar^{c1}$ and $Ar^{c2}$ each independently represent an aromatic hydrocarbon group having 6 to 20 carbon atoms, and $n^{c1}$ represents an integer of 3 to 20.)

[Chem. 2]

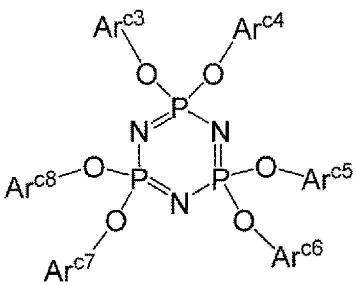

(C-2-2)

(In the formula, $Ar^{c3}$ to $Ar^{c8}$ each independently represents an aromatic hydrocarbon group having 6 to 20 carbon atoms.)

The description of the aromatic hydrocarbons having 6 to 20 carbon atoms represented by $Ar^{c1}$ and $Ar^{c2}$ in the above general formula (C-2-1) and the aromatic hydrocarbon group having 6 to 20 carbon atoms represented by $Ar^{c3}$ to $Ar^{c8}$ in the above general formula (C-2-2) is the same as the description of the aromatic hydrocarbon group having 6 to 20 carbon atoms represented by $R^{c8}$ and $R^{c9}$ in the above general formula (C-1).

$n^{c1}$ in the above general formula (C-2-1) represents an integer of 3 to 20, preferably an integer of 3 to 10, more preferably an integer of 3 to 5, and still more preferably 3.

(Phosphate Ester Compound)

As the phosphate ester compound, an aromatic phosphate ester is preferable. The aromatic phosphate ester is a phosphate ester having an aromatic hydrocarbon group.

Specific examples of the phosphate ester compound include triphenyl phosphate, tricresyl phosphate, trixylenyl phosphate, cresyl diphenyl phosphate, cresyl di-2,6-xylenyl phosphate, 1,3-phenylene-bis(di-2,6-dimethylphenyl phosphate), 1,3-phenylene-bis(diphenyl phosphate), bisphenol A bis(diphenyl phosphate), 1,4-phenylene-bis(di-2,6-dimethylphenyl phosphate), 4,4'-biphenylene-bis(di-2,6-dimethylphenyl phosphate), bisphenol A-polyphenyl phosphate, 4,4'-biphenol-polycresyl phosphate, bisphenol A-polycresyl phosphate, 4,4'-biphenol-poly(2,6-xylylene phosphate), and bisphenol A-poly(2,6-xylylene phosphate).

(Phosphaphenanthrene Compound)

Examples of the phosphaphenanthrene include 9,10-dihydro-9-oxa-10-phosphaphenanthrene 10-oxide, and 9,10-dihydro-10-(2,5-dihydroxyphenyl)-9-oxa-10-phosphaphenanthrene 10-oxide.
The content of the phosphorus-based flame retardant (C) in the resin composition of the present embodiment is preferably 3 to 40% by mass, more preferably 4 to 30% by mass, and still more preferably 4 to 20% by mass, with respect to the total amount of solid content (100% by mass) of the resin composition.
When the content of the phosphorus-based flame retardant (C) is the above lower limit value or more, the minimum melt viscosity tends to be more easily improved. On the other hand, when the content of the phosphorus-based flame retardant (C) is equal to or less than the above upper limit value, the dielectric characteristics tend to be more easily improved.

<(D) Epoxy Resin>

The resin composition of the present embodiment preferably further contains (D) an epoxy resin.
The resin composition of the present embodiment tends to have better heat resistance by containing the epoxy resin (D).
The epoxy resin (D) may be used alone or may be used in combination of two or more kinds thereof.
The epoxy resin (D) is preferably an epoxy resin having two or more epoxy groups.
The epoxy resin (D) is classified into a glycidyl ether type epoxy resin, a glycidyl amine type epoxy resin, and a glycidyl ester type epoxy resin. Among these, a glycidyl ether type epoxy resin is preferable.
The epoxy resins (D) are also classified into various epoxy resins depending on the main backbone, and in each of the above types of epoxy resins, epoxy resins are further classified into bisphenol type epoxy resins such as a bisphenol A type epoxy resin, a bisphenol F type epoxy resin, and a bisphenol S type epoxy resin; alicyclic epoxy resins such as a dicyclopentadiene type epoxy resin; aliphatic linear epoxy resins; novolac type epoxy resins such as a phenol novolac type epoxy resin, a cresol novolac type epoxy resin, a bisphenol A novolac type epoxy resin, a bisphenol F novolac type epoxy resin, a phenol aralkyl novolac type epoxy resin, and a biphenyl aralkyl novolac type epoxy resin; stilbene type epoxy resins; naphthalene skeleton-containing epoxy resins such as a naphthol novolac type epoxy resin and a naphthol aralkyl type epoxy resin; biphenyl type epoxy resins; xylylene type epoxy resins; and dihydroanthracene type epoxy resins.
Among these, as the epoxy resin (D), from the viewpoint of heat resistance and low thermal expansion property, a naphthalene skeleton-containing epoxy resin is preferable, and a naphthol aralkyl type epoxy resin is more preferable.
In a case where the resin composition of the present embodiment contains the epoxy resin (D), the content of the epoxy resin (D) is preferably 1 to 30% by mass, more preferably 3 to 20% by mass, and still more preferably 5 to 10% by mass with respect to the total amount (100% by mass) of the resin components in the resin composition.
When the content of the epoxy resin (D) is equal to or more than the above lower limit value, the heat resistance tends to be more easily improved. On the other hand, when the content of the epoxy resin (D) is equal to or less than the above upper limit value, the low thermal expansion property tends to be more easily improved.

<(E) Inorganic Filler>

The resin composition of the present embodiment preferably further contains (E) an inorganic filler.
By containing the inorganic filler (E), the resin composition of the present embodiment tends to easily obtain more excellent low thermal expansion property and heat resistance.
The inorganic filler (E) may be used alone or may be used in combination of two or more kinds thereof.
Examples of the inorganic filler (D) include silica, alumina, titanium oxide, mica, beryllia, barium titanate, potassium titanate, strontium titanate, calcium titanate, aluminum carbonate, calcium carbonate, magnesium hydroxide, aluminum hydroxide, aluminum silicate, calcium silicate, magnesium silicate, silicon nitride, boron nitride, clay, talc, aluminum borate, and silicon carbide. Among these, from the viewpoint of low thermal expansion property, heat resistance, and flame retardancy, silica, alumina, mica, and talc are preferable, silica and alumina are more preferable, and silica is still more preferable.
The silica is preferably fused silica from the viewpoint of dispersibility and moldability.
The average particle diameter ($D_{50}$) of the inorganic filler (E) is preferably 0.1 to 10 μm, more preferably 0.2 to 1 μm, and still more preferably 0.3 to 0.8 μm, from the viewpoint of dispersibility and fine wiring properties.
The average particle diameter ($D_{50}$) of the inorganic filler (E) in the description herein is a particle diameter at a point corresponding to 50% by volume when a cumulative frequency distribution curve based on the particle diameter is obtained with the total volume of the particles as 100%. The average particle diameter of the inorganic filler (E) can be measured by, for example, a particle size distribution analyzer using a laser diffraction scattering method.
Examples of the shape of the inorganic filler (E) include a spherical shape and a crushed shape, and a spherical

shape is preferable.

The inorganic filler (E) may be surface-treated with, for example, a surface treatment agent such as a silane coupling agent from the viewpoint of improving the dispersibility and the adhesion to the organic component.

In a case where the resin composition of the present embodiment contains the inorganic filler (E), the content of the inorganic filler (E) is preferably 30 to 90% by mass, more preferably 40 to 85% by mass, and still more preferably 60 to 80% by mass, with respect to the total amount of solid content (100% by mass) of the resin composition.

When the content of the inorganic filler (E) is equal to or more than the above lower limit value, the low thermal expansion property and the heat resistance tend to be more easily improved. On the other hand, when the content of the inorganic filler (E) is equal to or less than the above upper limit value, the moldability and the adhesiveness to a copper foil tend to be more easily improved.

<(F) Curing Accelerator>

The resin composition of the present embodiment preferably further contains (F) a curing accelerator.

By containing the curing accelerator (F), the resin composition of the present embodiment tends to have an improved curability and easily obtain more excellent adhesiveness to a copper foil.

The curing accelerator (F) may be used alone or may be used in combination of two or more kinds thereof.

Examples of the curing accelerator (F) include acidic catalysts such as p-toluenesulfonic acid; amine compounds such as triethylamine, tributylamine, pyridine, and dicyandiamide; imidazole compounds such as methylimidazole, phenylimidazole, 1-cyanoethyl-2-phenylimidazole, and 1-cyanoethyl-2-phenylimidazolium trimellitate; isocyanate-masked imidazole compounds such as an addition reaction product of hexamethylene diisocyanate resin and 2-ethyl-4-methylimidazole; quaternary ammonium compounds; phosphorus-based compounds such as triphenylphosphine; organic peroxides such as dicumyl peroxide, 2,5-dimethyl-2,5-bis(t-butylperoxy)hexyne-3,2,5-dimethyl-2,5-bis(t-butylperoxy)hexane, t-butylperoxyisopropyl monocarbonate, and $\alpha,\alpha'$-bis(t-butylperoxy)diisopropylbenzene; and carboxylates of manganese, cobalt, zinc, and the like.

Among these, an isocyanate-masked imidazole compound is preferable from the viewpoint of curing accelerating effect and storage stability.

In a case where the resin composition of the present embodiment contains the curing accelerator (F), the content of the curing accelerator (F) is preferably 0.01 to 10 parts by mass, more preferably 0.05 to 5 parts by mass, and still more preferably 0.1 to 1 part by mass, with respect to 100 parts by mass of the total amount of the resin components in the resin composition.

When the content of the curing accelerator (F) is equal to or more than the above lower limit value, sufficient curing acceleration effect tends to be easily obtained. On the other hand, when the content of the curing accelerator (F) is equal to or less than the above upper limit value, storage stability tends to be more easily improved.

<Other Optional Components>

The resin composition of the present embodiment may further contain, if necessary, one or more other optional components selected from the group consisting of a resin material other than the above-mentioned components, an antioxidant, a thermal stabilizer, an antistatic agent, an ultraviolet absorber, a pigment, a colorant, a lubricant, an organic solvent, and additives other than these.

For each of the above optional components, one kind may be used alone, or two or more kinds may be used in combination.

The content of the optional component in the resin composition of the present embodiment is not particularly limited, and the optional component may be used as necessary within a range that does not impair the effects of the present embodiment.

In addition, the resin composition of the present embodiment may not contain the above-mentioned optional components depending on the desired performance.

(Organic Solvent)

The resin composition of the present embodiment may contain an organic solvent from the viewpoint of facilitating handling.

Examples of the organic solvent include, for example, alcohol-based solvents such as ethanol, propanol, butanol, methyl cellosolve, butyl cellosolve, and propylene glycol monomethyl ether; ketone-based solvents such as acetone, methyl ethyl ketone, methyl isobutyl ketone, and cyclohexanone; ether-based solvents such as tetrahydrofuran; aromatic hydrocarbon-based solvents such as toluene, xylene, and mesitylene; nitrogen atom-containing solvents such as dimethylformamide, dimethylacetamide, and N-methylpyrrolidone; sulfur atom-containing solvents such as dimethyl

sulfoxide; and ester-based solvents such as γ-butyrolactone.

Among these, from the viewpoint of solubility, an alcohol-based solvent, a ketone-based solvent, a nitrogen atom-containing solvent, and an aromatic hydrocarbon-based solvent are preferable, an aromatic hydrocarbon-based solvent is more preferable, and toluene is still more preferable.

<Method for Producing Resin Composition>

The resin composition of the present embodiment can be produced by mixing the respective components. In this case, the respective components may be dissolved or dispersed while stirring. Conditions such as mixing order, temperature, and time are not particularly limited, and may be arbitrarily set according to the type of raw material.

[Prepreg]

The prepreg of the present embodiment is a prepreg containing the resin composition of the present embodiment and a fiber substrate.

The thickness of the fiber substrate is preferably 5 to 200 μm, more preferably 20 to 150 μm, and still more preferably 50 to 110 μm from the viewpoint of mechanical strength of the prepreg and high density wiring.

The fiber substrate has a shape of, for example, a woven fabric, a nonwoven fabric, a roving, a chopped strand mat, or a surfacing mat.

The fiber substrate may be surface-treated with a coupling agent or may be subjected to a mechanical opening treatment from the viewpoint of the impregnation property of the resin composition and the like.

Examples of the fibers constituting the fiber substrate include inorganic fibers such as glass fibers; organic fibers such as polyimide, polyester, and tetrafluoroethylene; and mixtures thereof. Among these, inorganic fibers are preferable, and glass fibers are more preferable, from the viewpoint of low thermal expansion property. From the same viewpoint, the fiber substrate is preferably a glass cloth.

Examples of the glass fibers include E-glass, D-glass, T-glass, S-glass, and quartz glass. Among these, from the viewpoint of low thermal expansion property, one or more selected from the group consisting of D-glass, T-glass, and S-glass are preferable, and S-glass is more preferable. That is, the glass cloth is preferably made of S-glass.

Typical compositions of E-glass, D-glass, T-glass, and S-glass are as follows.

- E-glass: $SiO_2$ (52 to 56% by mass), $Al_2O_3$ (12 to 16% by mass), $Fe_2O_3$ (0 to 0.8% by mass), $B_2O_3$ (5 to 10% by mass), CaO (16 to 25% by mass), MgO (0 to 6% by mass), $Na_2O$ + $K_2O$ (0 to 2% by mass), $TiO_2$ (0 to 1.5% by mass), $F_2$ (0 to 1% by mass)
- D-glass: $SiO_2$ (74% by mass), $Al_2O_3$ (0.5% by mass), $B_2O_3$ (22% by mass), CaO (0.5% by mass), $Na_2O$ (1% by mass), $K_2O$ (1.5% by mass), $Li_2O$ (0.5% by mass)
- T-glass: $SiO_2$ (64 to 66% by mass), $Al_2O_3$ (24 to 26% by mass), MgO (9 to 11% by mass)
- S-glass: $SiO_2$ (62 to 65% by mass), $Al_2O_3$ (20 to 25% by mass), CaO (0 to 0.01% by mass), MgO (10 to 15% by mass), $B_2O_3$ (0 to 0.01% by mass), $Na_2O$ and $K_2O$ (0 to 1% by mass)

The content of $SiO_2$ in the glass fibers is not particularly limited, and is preferably 30% by mass or more, more preferably 40% by mass or more, still more preferably 50% by mass or more, and particularly preferably 60% by mass or more. On the other hand, the content of $SiO_2$ in the glass fibers is not particularly limited, and is preferably 95% by mass or less, more preferably 90% by mass or less, still more preferably 80% by mass or less, and particularly preferably 75% by mass or less.

In addition, the content of the $SiO_2$ in the glass fibers is preferably 40 to 90% by mass, more preferably 50 to 80% by mass, and still more preferably 60 to 75% by mass, from the viewpoint of low thermal expansion property and processability.

The basis weight of the glass cloth is preferably 10 to 210 $g/m^2$, more preferably 50 to 180 $g/m^2$, and still more preferably 100 to 130 $g/m^2$, from the viewpoint of mechanical strength of the prepreg and high density wiring.

The prepreg of the present embodiment can be produced by, for example, impregnating or coating the resin composition of the present embodiment into a fiber substrate and then heating and drying the impregnated or coated resin composition to make it B-stage.

The temperature and time of the heating and drying may be, for example, set to 50 to 200°C and 1 to 30 minutes from the viewpoint of productivity and appropriately bringing the resin composition of the present embodiment into the B-stage.

The content of the resin composition in the prepreg of the present embodiment is preferably 30 to 80% by mass, more preferably 35 to 70% by mass, and still more preferably 40 to 60% by mass from the viewpoint of moldability.

[Laminated Plate]

The laminated plate of the present embodiment is a laminated plate having a cured product of the resin composition of the present embodiment, and a metal foil. The laminated plate having a metal foil may also be referred to as a metal-clad laminated plate.
Examples of the metal of the metal foil include copper, gold, silver, nickel, platinum, molybdenum, ruthenium, aluminum, tungsten, iron, titanium, chromium, and an alloy containing one or more kinds of these metal elements.
The laminated plate of the present embodiment can be produced, for example, by disposing a metal foil on one surface or both surfaces of the prepreg of the present embodiment, and then subjecting the prepreg to heating and press molding.
Usually, the B-staged prepreg is cured by this heating and press molding to obtain the laminated plate of the present embodiment.
When the heating and press molding is performed, only one sheet of prepreg may be used, or two or more sheets of prepreg may be laminated and used.
For the heating and press molding, for example, a multi-stage press, a multi-stage vacuum press, a continuous molding, or an autoclave molding machine can be used.
As the conditions of the heating and press molding, the temperature may be 100 to 300°C, the time may be 10 to 300 minutes, and the pressure may be 1.5 to 5 MPa, for example.

[Printed Wiring Board]

The printed wiring board of the present embodiment is a printed wiring board having a cured product of the resin composition of the present embodiment.
The printed wiring board of the present embodiment can be produced by, for example, forming a conductor circuit on the cured product of the prepreg of the present embodiment by a known method. In addition, a multilayer printed wiring board can also be produced by performing a multilayer adhesion process as necessary. The conductor circuit can be formed by, for example, appropriately performing a drilling process, a metal plating process, or etching of a metal foil.

[Semiconductor Package]

The semiconductor package of the present embodiment is a semiconductor package including the printed wiring board of the present embodiment and a semiconductor element.
The semiconductor package of the present embodiment can be produced, for example, by mounting a semiconductor chip and a memory on the printed wiring board of the present embodiment by a known method.

Examples

Hereinafter, the present embodiment will be specifically described with reference to Examples. However, the present embodiment is not limited to the following Examples.
In each example, weight-average molecular weight (Mw) was measured by the following method.
It was converted from a calibration curve using standard polystyrene by gel permeation chromatography (GPC). The calibration curve was approximated by a cubic equation using standard polystyrene: TSK standard POLYSTYRENE (Type; A-2500, A-5000, F-1, F-2, F-4, F-10, F-20, F-40) (manufactured by Tosoh Corporation, trade name). The measurement conditions of GPC are shown below.
Device:

Pump: L-6200 type (manufactured by Hitachi High-Tech Corporation)
Detector: L-3300 type RI (manufactured by Hitachi High-Tech Corporation)
Column oven: L-655A-52 (manufactured by Hitachi High-Tech Corporation)
Column: Guard column; TSK Guardcolumn HHR-L + column; TSKgel G4000HHR + TSKgel G2000HHR (all manufactured by Tosoh Corporation, trade name)
Column size: 6.0 × 40 mm (guard column), 7.8 × 300 mm (column)
Eluent: tetrahydrofuran
Sample concentration: 30 mg/5 mL
Injection volume: 20 μL
Flow rate: 1.00 mL/min
Measurement temperature: 40°C

Production Example 1: Production of siloxane-modified maleimide resin

In a reaction vessel having a volume of 2 L capable of heating and cooling and equipped with a thermometer, a stirring device, and a moisture determination device with a reflux cooling pipe, 100 g of diamine-modified siloxane at both terminals (trade name: X-22-161A, manufactured by Shin-Etsu Chemical Co., Ltd., functional group equivalent of amino group: 800 g/mol), 450 g of 2,2-bis[4-(4-maleimidophenoxy)phenyl]propane, and 550 g of propylene glycol monomethyl ether were placed, and then reacted at 120°C for 3 hours to produce a siloxane-modified maleimide resin. The weight-average molecular weight (Mw) of the obtained siloxane-modified maleimide resin was 2,500.

Examples 1 and 2 and Comparative Examples 1 to 7

(Production of Resin Composition)

Each of the components listed in Table 1 was stirred and mixed with methyl ethyl ketone to prepare a varnish-like resin composition having a solid content concentration of 50% by mass. In Table 1, the unit of the blending amount of each component is parts by mass, and in the case of a solution, the unit means parts by mass in terms of solid content.

(Production of Prepreg)

A glass cloth (basis weight: 114 g/$m^2$, type of glass: S-glass, thickness of glass cloth: 98 μm) was impregnated with the varnish-like resin composition obtained above and heated and dried at 120°C for 5 minutes to obtain a prepreg. The content of the resin composition in the prepreg was 50% by mass.

(Production of Copper-Clad Laminated Plate)

Four sheets of the prepreg obtained above were stacked, and a copper foil having a thickness of 12 μm (manufactured by Mitsui Mining & Smelting Co., Ltd., trade name "3EC-M3-VLP-12", Rz of M surface: 3.0 μm) was disposed on the upper and lower sides thereof so that the M surface was in contact with the prepreg. This laminate was subjected to heating and press molding for 80 minutes under the conditions of a temperature of 240°C and a pressure of 3.0 MPa to obtain a copper-clad laminated plate.

[Evaluation Methods]

Each evaluation was carried out according to the following methods. The results are shown in Table 1.

(Method for Measuring Coefficient of Thermal Expansion)

The copper foils on both surfaces of the copper-clad laminated plate obtained in each example were removed by etching to prepare a 5 mm square test piece. Next, the test piece was mounted on a thermomechanical analyzer (TMA) (manufactured by TA Instruments Japan Inc., trade name "Q400"), and thermomechanical analysis was continuously performed twice by a compression method under the conditions of a temperature range of 30 to 260°C, a load of 5 g, and a temperature raising rate of 10°C/min. The average coefficient of thermal expansion from 30°C to 100°C in the second measurement was defined as the coefficient of thermal expansion. The coefficient of thermal expansion is a coefficient of thermal expansion in the plane direction of the copper-clad laminated plate.

(Method for Measuring Copper Foil Peel Strength)

The copper foil of the copper-clad laminated plate obtained in each example was processed by etching into a straight line shape having a width of 5 mm and used as a test piece. The formed straight line-shaped copper foil was attached to a compact desktop tester (manufactured by Shimadzu Corporation, trade name: "EZ-TEST"), and the copper foil peel strength was measured by peeling in a 90° direction at room temperature (25°C). The pulling speed for peeling the copper foil was 50 mm/min.

(Method for Measuring Minimum Melt Viscosity and Minimum Melt Viscosity Attainment Temperature)

About 0.6 g of resin powder in a B-stage state collected by loosening the prepreg obtained in each example was weighed and molded into a disc-shaped tablet having a diameter of 20 mm using a tablet molding machine. Using this tablet as a measuring sample, the melt viscosity was measured using a rheometer (manufactured by Rheometric

Scientific, trade name "ARES-2K STD-FCO-STD") under the conditions of a temperature raising rate of 3°C/min, a load of 0.2 N, and a temperature range of 50 to 200°C, and the minimum melt viscosity and the minimum melt viscosity attainment temperature were acquired. The minimum melt viscosity attainment temperature means a temperature at which the minimum melt viscosity is exhibited.

[Table 1]

Table 1

| | | | Examples | | Comparative Example | | |
|---|---|---|---|---|---|---|---|
| | | | 1 | 2 | 1 | 2 | 3 |
| Blending composition (parts by mass) | Component (A) | Siloxane-modified maleimide resin | 55 | 55 | 55 | 55 | 55 |
| | Component (B) | Butadiene-based polymer 1 | 20 | | | 40 | |
| | | Butadiene-based polymer 2 | | 20 | | | 40 |
| | Comparative component | Acrylic polymer | | | 20 | | |
| | Component (C) | Phosphorus-based flame retardant | 20 | 20 | 20 | | |
| | Component (D) | Epoxy resin | 5 | 5 | 5 | 5 | 5 |
| | Component (E) | Fused silica | 160 | 160 | 160 | 160 | 160 |
| | Component (F) | Curing accelerator | 0.4 | 0.4 | 0.4 | 0.4 | 0.4 |
| Evaluation results | Coefficient of thermal expansion (ppm/°C) | | 4.8 | 4.8 | 4.5 | 5.0 | 4.5 |
| | Copper foil peel strength (kN/m) | | 0.4 | 0.3 | 0.3 | 0.3 | 0.2 |
| | Minimum melt viscosity (Pa·s) | | 971 | 352 | 3349 | 9154 | 8114 |
| | Minimum melt viscosity attainment temperature (°C) | | 125 | 127 | 127 | 132 | 131 |

Table 1 (continued)

| | | | Comparative Example | | | |
|---|---|---|---|---|---|---|
| | | | 4 | 5 | 6 | 7 |
| Blending composition (parts by mass) | Component (A) | Siloxane-modified maleimide resin | 80 | 85 | 85 | 85 |
| | Component (B) | Butadiene-based polymer 1 | | | 10 | |
| | | Butadiene-based polymer 2 | | | | 10 |
| | Comparative component | Acrylic polymer | | 10 | | |
| | Component (C) | Phosphorus-based flame retardant | | | | |
| | Component (D) | Epoxy resin | 20 | 5 | 5 | 5 |
| | Component (E) | Fused silica | 160 | 160 | 160 | 160 |
| | Component (F) | Curing accelerator | 0.4 | 0.4 | 0.4 | 0.4 |
| Evaluation results | Coefficient of thermal expansion (ppm/°C) | | 7.1 | 5.8 | 6.0 | 5.8 |
| | Copper foil peel strength (kN/m) | | 0.8 | 0.4 | 0.5 | 0.6 |
| | Minimum melt viscosity (Pa·s) | | 1011 | 2372 | 5007 | 2640 |
| | Minimum melt viscosity attainment temperature (°C) | | 156 | 149 | 129 | 135 |

The details of the components shown in Table 1 are as follows.

[Component (A)]

- Siloxane-modified maleimide resin: Siloxane-modified maleimide resin produced in Production Example 1

[Component (B)]

- Butadiene-based polymer 1: maleic acid-modified polybutadiene, trade name "Ricon 130MA8", manufactured by Cray Valley, weight-average molecular weight (Mw): 3,100, average number of structural units derived from maleic acid in one molecule: 2, acid value: 46 mgKOH/g
- Butadiene-based polymer 2: maleic acid-modified polybutadiene, trade name "Lithene ultra PM4-7.5MA", manufactured by Synthomer, weight-average molecular weight (Mw): 1,600, average number of structural units derived from maleic acid in one molecule: 1.1, acid value: 40 mgKOH/g

[Comparative component]

•Acrylic polymer: trade name "TEISANRESIN (registered trademark) SG-P3", manufactured by Nagase ChemteX Corporation, acrylic polymer having an epoxy group, weight-average molecular weight (Mw): 850,000, epoxy equivalent: 4,800 g/eq

[Component (C)]

•Phosphorus-based flame retardant: phosphazene compound having the following structure, melting point: 90°C

[Chem. 3]

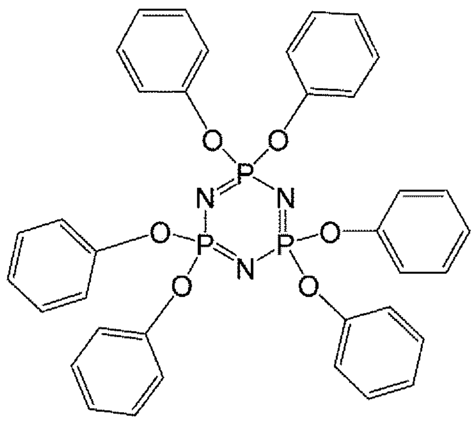

[Component (D)]

•Epoxy resin: naphthalene skeleton-containing epoxy resin, trade name "EPICLON (registered trademark) HP-9500", manufactured by DIC Corporation

[Component (E)]

•Fused silica: Average particle diameter ($D_{50}$) 0.5 μm, spherical fused silica

[Component (F)]

•Curing accelerator: isocyanate-masked imidazole, trade name "G-8009L", manufactured by DKS Co., Ltd.

From Table 1, it can be seen that the resin compositions of Examples 1 and 2 of the present embodiment are excellent in low thermal expansion property and minimum melt viscosity. On the other hand, the resin compositions of Comparative Examples 1 to 7 were inferior in at least one of low thermal expansion property and minimum melt viscosity.

## Claims

1. A resin composition comprising (A) a siloxane-modified maleimide resin, (B) a conjugated diene-based polymer, and (C) a phosphorus-based flame retardant.

2. The resin composition according to claim 1, wherein the component (C) has a melting point of 40 to 200°C.

3. The resin composition according to claim 1 or 2, wherein the component (C) is a phosphazene compound.

4. The resin composition according to claim 1 or 2, wherein a content of the component (C) is 3% to 40% by mass with respect to a total amount of solid content (100% by mass) in the resin composition.

5. The resin composition according to claim 1 or 2, wherein the component (B) is a butadiene-based polymer.

6. The resin composition according to claim 1 or 2, further comprising (D) an epoxy resin.

7. A prepreg comprising the resin composition according to claim 1 or 2 and a fiber substrate.

8. The prepreg according to claim 7, wherein the fiber substrate is a glass cloth.

9. The prepreg according to claim 8, wherein the glass cloth is composed of S-glass.

10. The prepreg according to claim 8, wherein a basis weight of the glass cloth is 10 to 210 $g/m^2$.

11. A laminated plate comprising a cured product of the resin composition according to claim 1 or 2, and a metal foil.

12. A printed wiring board comprising a cured product of the resin composition according to claim 1 or 2.

13. A semiconductor package comprising the printed wiring board according to claim 12, and a semiconductor element.

**INTERNATIONAL SEARCH REPORT**

International application No.
**PCT/JP2024/016070**

**A. CLASSIFICATION OF SUBJECT MATTER**

***C08L 79/00***(2006.01)i; ***B32B 15/08***(2006.01)i; ***B32B 27/00***(2006.01)i; ***B32B 27/18***(2006.01)i; ***C08J 5/24***(2006.01)i; ***C08K 5/5399***(2006.01)i; ***C08L 9/00***(2006.01)i; ***C08L 63/00***(2006.01)i; ***H05K 1/03***(2006.01)i
FI: C08L79/00 B; C08L9/00; C08K5/5399; C08L63/00 C; B32B15/08 Q; B32B27/00 104; B32B27/18 B; H05K1/03 610H; C08J5/24 CEQ

According to International Patent Classification (IPC) or to both national classification and IPC

**B. FIELDS SEARCHED**

Minimum documentation searched (classification system followed by classification symbols)

C08L; B32B27; C08J5/24; H05K1/03

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2019-123769 A (HITACHI CHEMICAL COMPANY, LTD.) 25 July 2019 (2019-07-25) claims 5, 10-12, paragraphs [0004], [0005], [0051], [0075], [0079], [0082]-[0084], examples 1-8 | 1-13 |
| Y | JP 2017-210546 A (HITACHI CHEMICAL COMPANY, LTD.) 30 November 2017 (2017-11-30) paragraph [0013] | 1-13 |
| Y | JP 2011-241343 A (SUMITOMO BAKELITE CO., LTD.) 01 December 2011 (2011-12-01) paragraph [0051] | 1-13 |
| Y | JP 2010-47696 A (SUMITOMO BAKELITE CO., LTD.) 04 March 2010 (2010-03-04) claims, paragraphs [0006], [0022] | 1-13 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **01 July 2024** | **23 July 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

INTERNATIONAL SEARCH REPORT

International application No. **PCT/JP2024/016070**

**C. DOCUMENTS CONSIDERED TO BE RELEVANT**

| Category* | Citation of document, with indication, where appropriate, of the relevant passages | Relevant to claim No. |
|---|---|---|
| Y | JP 2018-44065 A (TATSUTA ELECTRIC WIRE & CABLE CO., LTD.) 22 March 2018 (2018-03-22) claims, paragraph [0041], example 1 | 1-13 |
| Y | JP 2010-280893 A (HITACHI CHEMICAL CO., LTD.) 16 December 2010 (2010-12-16) claims, paragraphs [0001], [0068], examples | 1-13 |
| Y | US 2016/0122521 A1 (ELITE ELECTRONIC MATERIAL (KUNSHAN) CO., LTD.) 05 May 2016 (2016-05-05) claims, examples | 1-13 |
| Y | US 2013/0075138 A1 (YU, LI-CHIH) 28 March 2013 (2013-03-28) claims, paragraph [0024] | 1-13 |
| A | CN 110950901 A (SHENGYI TECHNOLOGY (SUZHOU) CO., LTD.) 03 April 2020 (2020-04-03) entire text | 1-13 |

Form PCT/ISA/210 (second sheet) (July 2022)

**INTERNATIONAL SEARCH REPORT**
**Information on patent family members**

International application No.
**PCT/JP2024/016070**

| Patent document cited in search report | Publication date (day/month/year) | Patent family member(s) | Publication date (day/month/year) |
|---|---|---|---|
| JP 2019-123769 A | 25 July 2019 | (Family: none) | |
| JP 2017-210546 A | 30 November 2017 | (Family: none) | |
| JP 2011-241343 A | 01 December 2011 | (Family: none) | |
| JP 2010-47696 A | 04 March 2010 | (Family: none) | |
| JP 2018-44065 A | 22 March 2018 | WO 2018/051715 A1<br>TW 201819536 A<br>CN 109689778 A<br>KR 10-2019-0054058 A | |
| JP 2010-280893 A | 16 December 2010 | (Family: none) | |
| US 2016/0122521 A1 | 05 May 2016 | CN 105542457 A<br>TW 201615673 A | |
| US 2013/0075138 A1 | 28 March 2013 | (Family: none) | |
| CN 110950901 A | 03 April 2020 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2017195902 A